# EUROPÄISCHE PATENTSCHRIFT

(11) **EP 2 308 105 B1**
(45) Veröffentlichungstag und Bekanntmachung des Hinweises auf die Patenterteilung: **04.09.2019**
(21) Anmeldenummer: 09775971.6
(22) Anmeldetag: 15.07.2009
(51) Int. Cl.: H01L 33/54, H01L 33/44

(54) **OPTOELEKTRONISCHES HALBLEITERBAUELEMENT**
OPTOELECTRONIC SEMICONDUCTOR COMPONENT
ÉLÉMENT SEMI-CONDUCTEUR OPTOÉLECTRONIQUE

(30) Priorität: 29.07.2008 DE 102008035255
(43) Veröffentlichungstag der Anmeldung: 13.04.2011
(73) Patentinhaber: OSRAM Opto Semiconductors GmbH, 93055 Regensburg (DE)
(72) Erfinder: BINDER, Michael, 85077 Manching (DE); LINKOV, Alexander, 93059 Regensburg (DE); ZEILER, Thomas, 93152 Nittendorf (DE); BRICK, Peter, 93051 Regensburg (DE)
(74) Vertreter: Epping - Hermann - Fischer
(86) Internationale Anmeldenummer: PCT/DE2009/000988
(87) Internationale Veröffentlichungsnummer: WO 2010/012264

(56) Entgegenhaltungen:
- WO-A1-2007/091696
- JP-A- 2006 059 851
- JP-A- 2006 100 529
- JP-A- 2006 245 066
- JP-A- 2007 142 277
- JP-A- 2007 294 728
- US-A1- 2003 089 914

## Beschreibung

Es wird ein optoelektronisches Halbleiterbauelement angegeben.

Die Druckschriften JP 2006-059851 A, JP 2007-294728 A und WO 2007/091696 A1 beschreiben jeweils ein optoelektronisches Halbleiterbauelement.

Gemäß der Erfindung umfasst das optoelektronische Halbleiterbauelement einen Anschlussträger. Bei dem Anschlussträger handelt es sich beispielsweise um eine Leiterplatte, die einen Grundkörper aus einem elektrisch isolierenden Material umfasst. Auf und/oder in den Grundkörper können elektrische Anschlussbahnen und Leiterbahnen strukturiert sein.

Gemäß der Erfindung umfasst das optoelektronische Halbleiterbauelement einen optoelektronischen Halbleiterchip. Bei dem optoelektronischen Halbleiterchip handelt es sich um einen strahlungsemittierenden oder strahlungsempfangenden Halbleiterchip. Beispielsweise handelt es sich bei dem optoelektronischen Halbleiterchip um einen Lumineszenzdiodenchip. Das heißt, der optoelektronische Halbleiterchip ist durch einen Leuchtdiodenchip oder einen Laserdiodenchip gegeben. Der optoelektronische Halbleiterchip ist auf einer Montagefläche des Anschlussträgers angeordnet. Der optoelektronische Halbleiterchip kann dort mechanisch befestigt und elektrisch kontaktiert sein.

Gemäß der Erfindung umfasst das optoelektronische Halbleiterbauelement einen strahlungsdurchlässigen Körper, der den Halbleiterchip umgibt. Bei dem strahlungsdurchlässigen Körper handelt es sich beispielsweise um einen Vergusskörper aus einem Vergussmaterial, mit dem der Halbleiterchip vergossen ist. Vorzugsweise umhüllt der strahlungsdurchlässige Körper den Halbleiterchip formschlüssig. Das heißt, der Halbleiterchip ist in das Material des strahlungsdurchlässigen Körpers eingebettet und an Flächen, welche nicht dem Anschlussträger zugewandt sind, formschlüssig vom Material des strahlungsdurchlässigen Körpers umgeben. Beispielsweise befindet sich der strahlungsdurchlässige Körper an diesen Flächen in direktem Kontakt mit dem Halbleiterchip. Der strahlungsdurchlässige Körper ist dabei zumindest für einen Teil der vom Halbleiterchip im Betrieb erzeugten elektromagnetischen Strahlung durchlässig.

Gemäß der Erfindung enthält der strahlungsdurchlässige Körper ein Silikon. Der strahlungsdurchlässige Körper kann dabei aus Silikon bestehen. Ferner ist es möglich, dass in den strahlungsdurchlässigen Körper Partikel anderer Materialien wie beispielsweise Diffusorpartikel, strahlungsabsorbierende Partikel oder Partikel eines Lumineszenzkonversionsstoffes eingebracht sind. Darüber hinaus ist es möglich, dass der strahlungsdurchlässige Körper aus einem Silikon-Epoxid-Hybridmaterial gebildet ist. Der strahlungsdurchlässige Körper weist dann beispielsweise 50 % Epoxidmaterial und 50 % Silikon auf.

Gemäß der Erfindung weist der strahlungsdurchlässige Körper zumindest eine Seitenfläche auf, die zumindest stellenweise in einem Winkel < 90° zur Montagefläche verläuft. Das heißt, die Seitenfläche verläuft nicht senkrecht zum Anschlussträger. Die Seitenfläche steht also nicht senkrecht auf der Montagefläche des Anschlussträgers. Vielmehr schließt zumindest ein Teil der Seitenfläche mit der Montagefläche einen Winkel ein, der < 90° ist. Dass die Seitenfläche mit der Montagefläche des Anschlussträgers einen Winkel < 90° aufweist, heißt auch, dass die Seitenfläche einen Flankenwinkel > 0° aufweist. Der Flankenwinkel ist dabei derjenige Winkel, den die Seitenfläche mit einer Oberflächennormalen auf die Montagefläche des Anschlussträgers aufweist.

Vorzugsweise ist die Seitenfläche dabei im Wesentlichen eben und die gesamte Seitenfläche schließt mit der Montagefläche des Anschlussträgers einen Winkel ein, der < 90° ist. "Im Wesentlichen eben" heißt dabei, dass die Seitenfläche eine Rauigkeit aufweisen kann, dass der makroskopische Verlauf der Seitenfläche jedoch eben beziehungsweise glatt ist.

Insgesamt weist das optoelektronische Halbleiterbauelement gemäß zumindest einer Ausführungsform also einen strahlungsdurchlässigen Körper auf, der zumindest eine angeschrägte oder schräge Seitenfläche aufweist. Der strahlungsdurchlässige Körper ist also nicht quaderförmig ausgebildet, sondern weist zumindest eine angeschrägte Seitenfläche auf.

Gemäß zumindest einer Ausführungsform des optoelektronischen Halbleiterbauelements ist die Seitenfläche durch einen Vereinzelungsprozess erzeugt. Das heißt, die Seitenfläche ist nicht durch ein Vergussverfahren mittels einer Form erzeugt, sondern die angeschrägte oder schräge Seitenfläche ist durch einen Vereinzelungsprozess erzeugt. Das heißt weiter, dass die Seitenfläche Spuren eines Vereinzelungsprozesses aufweist. Zum Beispiel weist die Seitenfläche Spuren eines Materialabtrags auf. Bei dem Merkmal, dass die Seitenfläche "durch einen Vereinzelungsprozess erzeugt ist", handelt es sich also um ein gegenständliches Merkmal, das aufgrund der Vereinzelungsspuren am fertigen optoelektronischen Halbleiterbauelement nachweisbar ist. Die Rauigkeit der durch den Vereinzelungsprozess erzeugten Seitenfläche hängt dabei vom Material des strahlungsdurchlässigen Körpers und vom verwendeten Vereinzelungsmittel - beispielsweise vom verwendeten Sägeblatt ab.

Gemäß zumindest einer Ausführungsform des optoelektronischen Halbleiterbauelements umfasst das optoelektronische Halbleiterbauelement einen Anschlussträger, einen optoelektronischen Halbleiterchip, der auf einer Montagefläche des Anschlussträgers angeordnet ist, und einen strahlungsdurchlässigen Körper, der den Halbleiterchip umgibt, wobei der strahlungsdurchlässige Körper ein Silikon enthält und der strahlungsdurchlässige Körper zumindest eine Seitenfläche aufweist, die zumindest stellenweise in einem Winkel < 90° zur Montagefläche verläuft und die Seitenfläche durch einen Vereinzelungsprozess erzeugt ist.

Dem optoelektronischen Halbleiterbauelement liegt dabei unter anderem die folgende Erkenntnis zugrunde: Herkömmlich wird ein strahlungsdurchlässiger Vergusskörper durch einen Vergussprozess in die gewünschte Form gebracht. Dabei muss der Vergusskörper zum optoelektronischen Halbleiterchip justiert werden. Diese Justage von Vergusskörper zu optoelektronischem Halbleiterchip ist aufwändig. Ferner ist es aufwändig, Anschlussträger mit den erforderlichen kleinen Toleranzen herzustellen. Wenn Seitenflächen des strahlungsdurchlässigen Körpers nach dem Vergießen durch einen Vereinzelungsprozess erzeugt werden, die optische Form des strahlungsdurchlässigen Vergusskörpers also erst nach dem Vergießen definiert wird, kann die Form des strahlungsdurchlässigen Körpers auf besonders einfache Weise geändert und der tatsächlichen Lage des optoelektronischen Halbleiterchips auf der Montagefläche des Anschlussträgers angepasst werden. Beispielsweise können dazu Justagemarken auf der Montagefläche des Anschlussträgers vorhanden sein, mit deren Hilfe eine besonders genaue Herstellung der schrägen Seitenflächen des strahlungsdurchlässigen Körpers erfolgen kann. Darüber hinaus hat sich gezeigt, dass mit Hilfe von angeschrägten oder schrägen Seitenflächen des strahlungsdurchlässigen Körpers die Auskoppeleffizienz von im Halbleiterchip erzeugter elektromagnetischer Strahlung durch den strahlungsdurchlässigen Körper aus dem optoelektronischen Halbleiterbauelement hinaus gesteigert ist.

Gemäß zumindest einer Ausführungsform des optoelektronischen Halbleiterchips ist die zumindest eine Seitenfläche, die zumindest stellenweise in einem Winkel < 90° zur Montagefläche verläuft, durch einen Sägeprozess erzeugt. Das heißt, die Seitenfläche weist dann Spuren eines Sägeprozesses auf. Die Seitenfläche kann beispielsweise Rillen aufweisen, welche durch die Sägeblätter erzeugt sind, mit denen die Seitenfläche erzeugt wurde.

Gemäß zumindest einer Ausführungsform des optoelektronischen Halbleiterbauelements weist der strahlungsdurchlässige Körper zumindest eine Seitenfläche auf, die zumindest stellenweise in einem Winkel zwischen 60° und 70° zur Montagefläche verläuft und durch einen Vereinzelungsprozess erzeugt ist. Es hat sich gezeigt, dass der Winkelbereich zwischen 60° und 70° zwischen schräger Seitenfläche und Montagefläche hinsichtlich der Auskoppelung von elektromagnetischer Strahlung aus dem strahlungsdurchlässigen Körper hinaus optimal sein kann. Gegenüber Seitenflächen, die in einem 90°-Winkel zur Montagefläche des Anschlussträgers verlaufen, kann die Auskoppeleffizienz bis zu 13 % gesteigert sein.

Gemäß zumindest einer Ausführungsform des optoelektronischen Halbleiterbauelements weist der strahlungsdurchlässige Körper zumindest zwei Seitenflächen auf, die jeweils zumindest stellenweise in einem Winkel < 90° zur Montagefläche verlaufen und jeweils durch einen Vereinzelungsprozess erzeugt sind. Vorzugsweise verlaufen die zumindest zwei Seitenflächen in einem Winkelbereich zwischen 60° und 70° zur Montagefläche.

Besonders bevorzugt verlaufen vier Seitenflächen des strahlungsdurchlässigen Körpers in einem Winkel zwischen 60° und 70° zur Montagefläche und sind durch einen Vereinzelungsprozess erzeugt. Die vier Seitenflächen sind dabei im Wesentlichen eben ausgebildet, das heißt abgesehen von Vereinzelungsspuren auf den Seitenflächen verlaufen die Seitenflächen eben.

Das heißt, der strahlungsdurchlässige Körper ist nach Art eines Pyramidenstumpfes geformt. Die Seitenflächen des Pyramidenstumpfes sind dabei durch einen Vereinzelungsprozess, insbesondere durch einen Sägeprozess erzeugt. Die Seitenflächen schließen vorzugsweise einen Winkel < 90°, besonders bevorzugt einen Winkel zwischen 60° und 70° mit der Montagefläche des Anschlussträgers ein. Der Pyramidenstumpf weist dabei beispielsweise eine rechteckige, zum Beispiel eine quadratische Grundfläche auf.

Gemäß zumindest einer Ausführungsform des optoelektronischen Halbleiterbauelements grenzt der strahlungsdurchlässige Körper direkt an die Montagefläche des Anschlussträgers. Das heißt, der strahlungsdurchlässige Körper befindet sich in direktem Kontakt mit der Montagefläche des Anschlussträgers. Darüber hinaus ist es möglich, dass zwischen strahlungsdurchlässigem Körper und Anschlussträger zumindest eine Schicht, beispielsweise eine Folie, angeordnet ist, welche eine Haftung zwischen dem strahlungsdurchlässigen Körper und dem Anschlussträger erhöht. Bei der Schicht kann es sich beispielsweise um eine Silikonfolie handeln.

Gemäß zumindest einer Ausführungsform des optoelektronischen Halbleiterbauelements ist der Anschlussträger mit einem keramischen Material gebildet. Der Anschlussträger kann beispielsweise einen Grundkörper aufweisen, der aus einem keramischen Material wie Aluminiumnitrid oder Aluminiumoxid besteht. An der Montagefläche des Anschlussträgers können auf den Grundkörper elektrische Anschlussbahnen und/oder Leiterbahnen strukturiert sein. Diese können beispielsweise durch Metallisierungen gebildet sein, die auf den Grundkörper aufgedampft oder auf andere Weise aufgebracht sind.

Darüber hinaus ist es möglich, dass der Anschlussträger auf seinem Grundkörper an der der Montagefläche abgewandten Seite zumindest zwei elektrische Anschlussstellen aufweist, über welche der Halbleiterchip des optoelektronischen Halbleiterbauelements elektrisch kontaktierbar ist. In diesem Fall ist das optoelektronische Halbleiterbauelement oberflächenmontierbar ausgebildet. Die Anschlussstellen können dabei mittels Durchbrüchen im Grundkörper des Anschlussträgers oder über Metallisierungen, die entlang von Seitenflächen des Anschlussträgers verlaufen, mit Anschlussstellen und Leiterbahnen auf der Montagefläche des Anschlussträgers elektrisch leitend verbunden sein.

Gemäß der Erfindung ist auf zumindest einer Seitenfläche des strahlungsdurchlässigen Körpers, die durch einen Vereinzelungsprozess erzeugt ist, eine Planarisierungsschicht aufgebracht. Aufgrund der Erzeugung der Seitenfläche durch einen Vereinzelungsprozess weist die Seitenfläche Vereinzelungsspuren auf. Diese Vereinzelungsspuren können zu einer optischen Störung des austretenden Lichts führen. Beispielsweise kann an diesen Vereinzelungsspuren eine unerwünschte Brechung oder Streuung des durch die Seitenfläche tretenden Lichts stattfinden. Um eine solche Brechung oder Streuung zu verhindern, kann auf die Seitenfläche eine Planarisierungsschicht aufgebracht sein, welche die Unebenheiten der Vereinzelungsspuren ausgleicht. Beispielsweise ist auf die Seitenfläche eine Schicht aus Silikon aufgesprüht.

Es wird darüber hinaus ein Verfahren zur Herstellung eines optoelektronischen Halbleiterbauelements angegeben. Mit dem Verfahren ist vorzugsweise ein optoelektronisches Halbleiterbauelement, wie es in Verbindung mit zumindest einem der vorangehenden Ausführungsformen beschrieben ist, herstellbar. Das heißt, sämtliche Merkmale, die in Verbindung mit dem optoelektronischen Halbleiterbauelement offenbart sind, sind auch in Verbindung mit dem Verfahren offenbart. Das Verfahren umfasst dabei vorzugsweise die folgenden Schritte:
- Bereitstellen eines Anschlussträgers,
- Befestigen und elektrisches Kontaktieren eines optoelektronischen Halbleiterchips auf einer Montagefläche des Anschlussträgers,
- Umformen des optoelektronischen Halbleiterchips mit einem strahlungsdurchlässigen Körper und
- Sägen des strahlungsdurchlässigen Körpers in einem Winkel < 90° zur Montagefläche des Anschlussträgers zum zumindest stellenweisen Erzeugen einer Seitenfläche des strahlungsdurchlässigen Körpers.

Die optische Form des strahlungsdurchlässigen Körpers wird über einen Vereinzelungsprozess - zum Beispiel einen Sägeprozess - definiert. Durch verschieden geformte Sägeblätter, die schnell und leicht zu wechseln sind, kann die Form des strahlungsdurchlässigen Körpers leicht verändert werden. Bei herkömmlichen Verguss-Techniken ist das mit erheblichen Kosten für die Modifizierung oder die Herstellung des Werkzeuges verbunden. Des Weiteren müssen bei herkömmlichen Verguss-Techniken die Toleranzen bei der Herstellung der Anschlussträger sehr klein gehalten werden oder zusätzliche aufwändige Prozessschritte wie ein Justageschritt durchgeführt werden, um die relative Position von Optik, das heißt von strahlungsdurchlässigem Körper, und Chip in vertretbaren Grenzen zu halten. Anschlussträger mit kleinen Toleranzen sind dabei erheblich teurer. Beim hier beschriebenen Verfahren definieren zum Beispiel Sägemarkierungen auf dem Anschlussträger, die bei herkömmlichen Verfahren lediglich für den Sägeprozess zum Vereinzeln der Bauteile dienen, gleichzeitig die Position der Optik relativ zum Halbleiterchip.

Gemäß zumindest einer Ausführungsform des Verfahrens wird der strahlungsdurchlässige Körper mittels Compression Molding (Formpressen), Liquid Transfer Molding (Flüssigspritzpressen), Liquid Injection Molding (Flüssigspritzgießen) oder Casting (Gießen) erzeugt, wobei der Anschlussträger einen Teil der Gießform bilden kann. Compression Molding stellt ein effektives Verfahren dar, um Vergusskörper für Halbleiterchips zu erstellen. Hierbei wird das Material für den Vergusskörper in die Form eingebracht und der Anschlussträger in das in der Form befindliche Material gedrückt.

In einer Abwandlung des Compression Molding kann auch festes, granulatförmiges Material, zum Beispiel Silikon-Epoxid-Hybridmaterial, verwendet werden. Hierbei kann das Material auch auf den Anschlussträger und den Halbleiterchip vor dem Schließen der Form aufgebracht werden. Die Abdichtung zwischen Anschlussträger und Gießform kann beispielsweise über eine Abdichtfolie erfolgen, die nach dem Compression Molding Prozess entfernt wird.

Werden feste, zum Beispiel in Tablettenform gepresste, Materialien, etwa Hybridmaterialien, verwendet, kann das Herstellen des Vergusskörpers auch mittels Transfer Molding erfolgen.

Zum Beispiel ist Liquid Injection Molding von Halbleiterbauteilen in der Druckschrift WO 2005/017995 A1 beschrieben. Casting von Halbleiterbauteilen ist in der Druckschrift EP 1 589 569 A2 und Liquid Transfer Molding von integrierten Halbleiterschaltkreisen ist in der Druckschrift US 2002/0153637 A1 beschrieben.

Gemäß der Erfindung wird nach der Herstellung der gesägten Seitenfläche eine Planarisierungsschicht auf die gesägten Seitenflächen des strahlungsdurchlässigen Körpers aufgesprüht. Die Planarisierungsschicht planarisiert Vereinzelungsspuren im strahlungsdurchlässigen Körper.

Im Folgenden wird das hier beschriebene optoelektronische Halbleiterbauelement anhand von Ausführungsbeispielen und den zugehörigen Figuren näher erläutert:
Die Figur 1A zeigt ein hier beschriebenes optoelektronisches Halbleiterbauelement gemäß einem ersten Ausführungsbeispiel in einer schematischen Schnittdarstellung.
Die Figur 1B zeigt eine Ausschnittsvergrößerung eines hier beschriebenen optoelektronischen Halbleiterbauelements in einem zweiten Ausführungsbeispiel.
Die Figur 1C zeigt in einer schematischen Auftragung die Auskoppeleffizienz in Abhängigkeit von der Oberflächenstreuung für ein Ausführungsbeispiel eines hier beschriebenen optoelektronischen Halbleiterbauelements.
Die Figur 2 zeigt eine schematische Perspektivdarstellung eines hier beschriebenen optoelektronischen Halbleiterbauelements gemäß einem weiteren Ausführungsbeispiel.
Die Figur 3 zeigt Simulationen der Auskoppeleffizienz in Abhängigkeit des Flankenwinkels für ein Ausführungsbeispiel eines hier beschriebenen optoelektronischen Halbleiterbauelements.
Die Figur 4 zeigt Simulationen der Auskoppeleffizienz in Abhängigkeit der Dicke des Grundkörpers des Anschlussträgers für ein Ausführungsbeispiel eines hier beschriebenen optoelektronischen Halbleiterbauelements.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

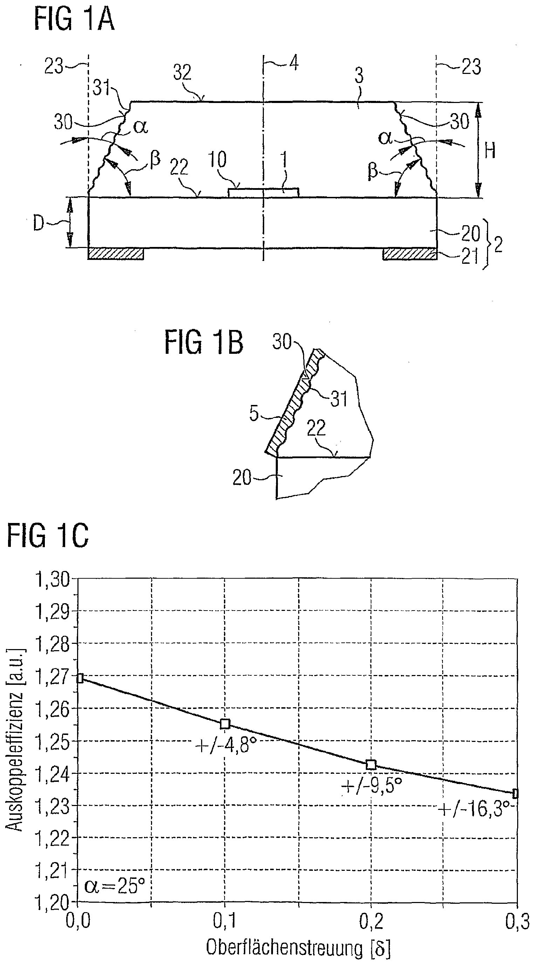

Die Figur 1A zeigt ein hier beschriebenes optoelektronisches Halbleiterbauelement gemäß einem ersten Ausführungsbeispiel in einer schematischen Schnittdarstellung. Das Halbleiterbauelement umfasst einen optoelektronischen Halbleiterchip 1. Vorliegend handelt es sich bei dem optoelektronischen Halbleiterchip 1 um einen Leuchtdiodenchip, der in Dünnfilmbauweise ausgeführt ist. Leuchtdiodenchips in Dünnfilmbauweise sind beispielsweise in den Druckschriften WO 02/13281 A1 sowie EP 0 905 797 A2 beschrieben, deren Offenbarungsgehalt hinsichtlich der Dünnfilmbauweise von Leuchtdiodenchips hiermit ausdrücklich durch Rückbezug aufgenommen wird.

Der optoelektronische Halbleiterchip 1 ist auf die Montagefläche 22 eines Anschlussträgers 2 aufgebracht. Der Anschlussträger 2 umfasst ferner einen Grundkörper 20, der vorliegend aus einem keramischen Material gebildet ist. Auf die der Montagefläche 22 gegenüberliegende Unterseite des Grundkörpers 20 des Anschlussträgers 2 sind elektrische Anschlussstellen 21 aufgebracht, über die das optoelektronische Halbleiterbauelement oberflächenmontierbar ist. Der optoelektronische Halbleiterchip 1 ist mit einem strahlungsdurchlässigen Körper 3 vergossen.

Der strahlungsdurchlässige Körper 3 umhüllt den optoelektronischen Halbleiterchip 1 formschlüssig. Der strahlungsdurchlässige Körper 3 besteht vorliegend aus einem Silikon. Der strahlungsdurchlässige Körper 3 grenzt direkt an die Montagefläche 22 des Anschlussträgers 2. Der strahlungsdurchlässige Körper 3 weist Seitenflächen 30 auf. Die Seitenflächen 30 verlaufen bis auf Vereinzelungsspuren 31, die in der Figur 1A zur besseren Sichtbarkeit übertrieben groß dargestellt sind, eben. Die Seitenflächen 30 schließen einen Winkel β < 90° mit der Montagefläche 22 des Anschlussträgers 2 ein. Das heißt, der Flankenwinkel a, der sich aus dem Winkel der Seitenfläche 30 zur Oberflächennormale 23 auf der Montagefläche 22 ergibt, ist > 0° .

Die Seitenflächen 30 sind durch einen Sägeprozess erzeugt. Bei den Vereinzelungsspuren 31 handelt es sich um Sägerillen oder andere Fehlstellen wie beispielsweise Vertiefungen, die durch ein "Herausreißen" von Material des strahlungsdurchlässigen Körpers 3 beim Sägen entstehen.

Der optoelektronische Halbleiterchip 1 kann zentriert zum strahlungsdurchlässigen Körper 3 und zum Anschlussträger 2 angeordnet sein. Das heißt, die optische Achse 4 durch das Zentrum der Strahlungsaustrittsfläche 10 des optoelektronischen Halbleiterchips 1 stellt dann eine Symmetrieachse des optoelektronischen Halbleiterbauelements dar. Die beschriebene Zentrierung ist vor allem hinsichtlich einer besonders symmetrischen Abstrahlung wünschenswert. Jedoch sind auch nicht-zentrierte Bauformen möglich.

Die Justage des optoelektronischen Halbleiterchips 1 relativ zum strahlungsdurchlässigen Körper 3 erfolgt dabei beim Vereinzelungsprozess beispielsweise mittels nicht dargestellter Justagemarken auf der Montagefläche 22 des Anschlussträgers 2.

Die Figur 1B zeigt einen vergrößerten Ausschnitt eines hier beschriebenen optoelektronischen Halbleiterbauelements gemäß einem zweiten Ausführungsbeispiel. Im Unterschied zum Ausführungsbeispiel, wie es in Verbindung mit Figur 1A beschrieben ist, ist in diesem Ausführungsbeispiel eine Planarisierungsschicht 5 auf der durch einen Vereinzelungsprozess erzeugten Seitenfläche 30 angeordnet. Die Planarisierungsschicht 5 ist dabei auf die Seitenfläche 30 aufgesprüht. Die Planarisierungsschicht 5 besteht vorliegend aus Silikon. Die Planarisierungsschicht 5 gleicht die durch die Vereinzelungsspuren 31 erzeugten Unebenheiten der Seitenfläche 30 aus.

Die Figur 1C zeigt hierzu in einer schematischen Auftragung die Auskoppeleffizienz bei einem Flankenwinkel α von 25° in Abhängigkeit von der Oberflächenstreuung am strahlungsdurchlässigen Körper 3. Dabei ist angenommen, dass der strahlungsdurchlässige Körper aus Silikon besteht und eine Höhe H von 400 µm aufweist. Der Grundkörper 20 des Anschlussträgers 2 besteht aus einem keramischen Material und weist eine Dicke D von 200 µm auf. Aus der Figur 1C wird ersichtlich, dass mit steigender Oberflächenstreuung an Seitenflächen 30 des strahlungsdurchlässigen Körpers 3 die Auskoppeleffizienz sinkt. Unebenheiten auf den Seitenflächen 30 des strahlungsdurchlässigen Körpers erhöhen die Oberflächenstreuung. Daher erweist sich die Planarisierungsschicht 5 im Hinblick auf die Auskoppeleffizienz als besonders vorteilhaft.

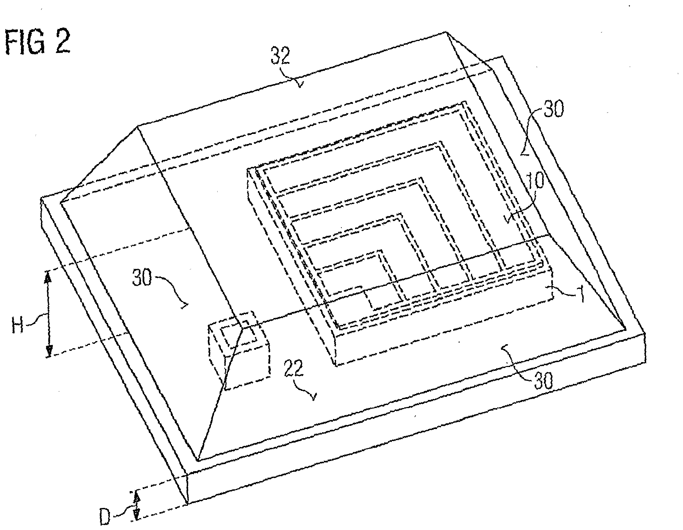

In Verbindung mit der Figur 2 ist anhand einer schematischen Perspektivdarstellung ein weiteres Ausführungsbeispiel eines hier beschriebenen optoelektronischen Halbleiterbauelements näher erläutert.

Wie der Figur 2 zu entnehmen ist, ist der strahlungsdurchlässige Körper 3 nach Art eines Pyramidenstumpfes ausgebildet, welcher vier schräge Seitenflächen 30 aufweist, die mittels eines Vereinzelungsprozesses - vorliegend Sägen - erzeugt sind.

Der Anschlussträger 2 weist einen Grundkörper 20 aus einem keramischen Material auf, der eine Dicke D von vorzugsweise wenigstens 0,2 mm und höchstens 0,5 mm, beispielsweise 0,4 mm aufweist. Der strahlungsdurchlässige Körper 3 weist eine Höhe H von vorzugsweise zwischen 0,55 mm und 0,25 mm, beispielsweise von 0,35 mm auf. Die Summe aus Dicke des Grundkörpers 20 und Höhe H des strahlungsdurchlässigen Körpers 3 beträgt vorzugsweise zwischen 0,7 mm und 0,8 mm, zum Beispiel 0,75 mm.

Der Flankenwinkel α beträgt zum Beispiel 25°. Der Flächeninhalt der Deckfläche 32 des strahlungsdurchlässigen Körpers beträgt vorzugsweise zwischen 2,0 und 2,5 mm², zum Beispiel 2,3 mm².

Der Anschlussträger 2 weist zum Beispiel eine Grundfläche von 2,04 mm x 1,64 mm auf.

Der optoelektronische Halbleiterchip 1 weist eine Strahlungsaustrittsfläche 10 auf, die einen Flächeninhalt von 500 µm² bis 1,5 mm², zum Beispiel 1,0 mm² aufweisen kann. Die Strahlungsaustrittsfläche 10 kann dabei quadratisch sein.

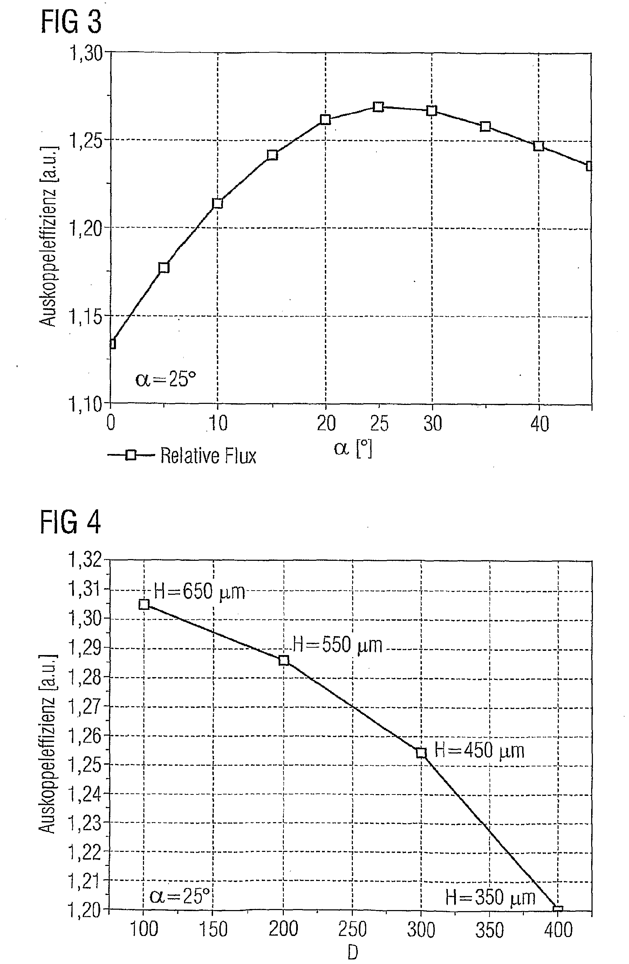

Die Figur 3 zeigt Simulationsergebnisse für die Auskoppeleffizienz eines optoelektronischen Halbleiterbauelements, wie es in Verbindung mit Figur 2 gezeigt ist.

Wie der Figur 3 zu entnehmen ist, erreicht die Auskoppeleffizienz für einen Flankenwinkel α = 25° ein Maximum. Die Auskoppeleffizienz ist dabei gegenüber einer Bauform mit einem Flankenwinkel = 0° um zirka 13 % erhöht. Das Maximum um den Flankenwinkel von 25° ist relativ flach, sodass sich für die optimale Auskoppelung ein breiter Winkeltoleranzbereich von +/- 5° ergibt, wodurch sich ein breites Prozessfenster für die Massenfertigung des optoelektronischen Halbleiterbauelements bietet. Der bevorzugte Winkelbereich für den Flankenwinkel liegt daher zwischen 20° und 30°, vorzugsweise bei 25°. Dieser optimale Winkel ist jedoch auch von der Größe der Grundfläche des Anschlussträgers 2 abhängig und kann daher für größere Bauformen abweichen. Wichtig ist, dass der strahlungsdurchlässige Körper zumindest eine Seitenfläche 30 aufweist, die zumindest stellenweise in einem Winkel β < 90° zur Montagefläche 22 verläuft.

Die Figur 4 zeigt Simulationsergebnisse für die Auskoppeleffizienz eines optoelektronischen Halbleiterbauelements, wie es in Verbindung mit Figur 2 gezeigt ist. Dabei ist die Auskoppeleffizienz gegen die Dicke D des Grundkörpers 20 des Anschlussträgers 2 aufgetragen. Die Höhe H des strahlungsdurchlässigen Körpers 3 ist jeweils so gewählt, dass die Summe aus Dicke D und Höhe H 750 µm ergibt. Wie der Figur zu entnehmen ist, ist die Auskoppeleffizienz umso größer, je dünner der Anschlussträger ist. Eine Dicke des Grundkörpers D von höchstens 250 µm ist daher bevorzugt. Die Erfindung ist nicht durch die Beschreibung anhand der Ausführungsbeispiele auf diese beschränkt. Diese Patentanmeldung beansprucht die Priorität der deutschen Patentanmeldung DE102008035255.1,

## Patentansprüche

1. Optoelektronisches Halbleiterbauelement mit
- einem Anschlussträger (2),
- einem optoelektronischen Halbleiterchip (1), der auf einer Montagefläche (22) des Anschlussträgers (2) angeordnet ist, und
- einem strahlungsdurchlässigen Körper (3), der den Halbleiterchip (1) umgibt, derart, dass der strahlungsdurchlässige Körper (3) Außenflächen des optoelektronischen Halbleiterchips (1), die nicht dem Anschlussträger (2) zugewandt sind, formschlüssig umhüllt, wobei
- der strahlungsdurchlässige Körper (3) ein Silikon enthält,
- der strahlungsdurchlässige Körper (3) zumindest eine Seitenfläche (30) aufweist, die in einem Winkel (β) kleiner 90° zur Montagefläche (22) verläuft,
- die Seitenfläche (30) Spuren eines Vereinzelungsprozesses aufweist, **dadurch gekennzeichnet, dass**
- auf die zumindest eine Seitenfläche (30) des strahlungsdurchlässigen Körpers (3), die durch einen Vereinzelungsprozess erzeugt ist, eine Planarisierungsschicht (5) aufgebracht ist.

2. Optoelektronisches Halbleiterbauelement nach dem vorherigen Anspruch,
bei dem
- die Seitenflächen (30) durch einen Sägeprozess erzeugt sind.

3. Optoelektronisches Halbleiterbauelement nach einem der vorherigen Ansprüche,
bei dem
- der strahlungsdurchlässige Körper (3) zumindest eine Seitenfläche (30) aufweist, die zumindest stellenweise in einem Winkel (β) zwischen 60° und 70° zur Montagefläche (22) verläuft und durch einen Vereinzelungsprozess erzeugt ist.

4. Optoelektronisches Halbleiterbauelement nach einem der vorherigen Ansprüche,
bei dem
- der strahlungsdurchlässige Körper (3) zumindest zwei Seitenflächen (30) aufweist, die jeweils zumindest stellenweise in einem Winkel (β) kleiner 90° zur Montagefläche verlaufen und jeweils durch einen Vereinzelungsprozess erzeugt sind.

5. Optoelektronisches Halbleiterbauelement nach dem vorherigen Anspruch,
bei dem
- der strahlungsdurchlässige Körper (3) zumindest zwei Seitenflächen (30) aufweist, die jeweils zumindest stellenweise in einem Winkel (β) zwischen 60° und 70° zur Montagefläche (22) verlaufen und jeweils durch einen Vereinzelungsprozess erzeugt sind.

6. Optoelektronisches Halbleiterbauelement nach einem der vorherigen Ansprüche,
bei dem
- der strahlungsdurchlässige Körper (3) direkt an die Montagefläche (22) des Anschlussträgers (2) grenzt.

7. Optoelektronisches Halbleiterbauelement nach einem der vorherigen Ansprüche,
bei dem
- der Anschlussträger (2) einen Grundkörper (20) aufweist, der mit einem keramischen Material gebildet ist, wobei der Grundkörper (20) eine Dicke (D) aufweist, die höchstens 250 µm beträgt.

8. Verfahren zur Herstellung eines optoelektronischen Halbleiterbauelements nach zumindest einem der vorherigen Ansprüche mit den folgenden Schritten:
- Bereitstellen eines Anschlussträgers (2),
- Befestigen und elektrisches Kontaktieren eines optoelektronischen Halbleiterchips (1) auf einer Montagefläche (22) des Anschlussträgers (2),
- Umformen des optoelektronischen Halbleiterchips (1) mit einem strahlungsdurchlässigen Körper (3), und
- Sägen des strahlungsdurchlässigen Körpers (3) in einem Winkel < 90° zur Montagefläche (22) des Anschlussträgers (2) zum zumindest stellenweisen Erzeugen einer Seitenfläche (30) des strahlungsdurchlässigen Körpers, **dadurch gekennzeichnet, dass**
- eine Planarisierungsschicht (5) auf die gesägte Seitenfläche (30) des strahlungsdurchlässigen Körpers (3) aufgesprüht wird.

## Claims

1. Optoelectronic semiconductor component with
- a connection carrier (2),
- an optoelectronic semiconductor chip (1) that is arranged on a mounting surface (22) of the connection carrier (2), and
- a radiation-transmissive body that surrounds the semiconductor chip (1) in such a way that the radiation-transmissive body (3) encases outer surfaces of the optoelectronic semiconductor chip (1) which are not facing the connection carrier (2) in a form-fitting manner, wherein
- the radiation-transmissive body (3) contains a silicone,
- the radiation-transmissive body (3) has at least one side surface (30), which extends at an angle (β) of less than 90° to the mounting surface (22),
- the side surface (30) has signs of a singulation process, **characterized in that**
- on the at least one side surface (30) of the radiation-transmissive body (3) which is produced by a singulation process, a planarization layer (5) is applied.

2. Optoelectronic semiconductor component according to the preceding claim,
wherein
- the side surfaces (30) are produced by a sawing process.

3. Optoelectronic semiconductor component according to one of the preceding claims,
wherein
- the radiation-transmissive body (3) has at least one side surface (30) which extends at least in places at an angle (β) between 60° and 70° to the mounting surface (22) and is produced by a singulation process.

4. Optoelectronic semiconductor component according to one of the preceding claims,
wherein
- the radiation-transmissive body (3) has at least two side surfaces (30) which extend at least in places at an angle (β) of less than 90° to the mounting surface and are each produced by a singulation process.

5. Optoelectronic semiconductor component according to the preceding claim,
wherein
- the radiation-transmissive body (3) has at least two side surfaces (30) which extend at least in places at an angle (β) between 60° and 70° to the mounting surface (22) and are each produced by a singulation process.

6. Optoelectronic semiconductor component according to one of the preceding claims,
wherein
- the radiation-transmissive body (3) is directly adjacent to the mounting surface (22) of the connection carrier (2).

7. Optoelectronic semiconductor component according to one of the preceding claims,
wherein
- the connection carrier (2) comprises a base body (20) which is formed with a ceramic material, wherein the base body (20) has a thickness (D) which is not more than 250 µm.

8. Method for producing an optoelectronic semiconductor component according to at least one of the preceding claims with the following steps:
- providing of a connection carrier (2),
- mounting and electrically contacting an optoelectronic semiconductor chip (1) on a mounting surface (22) of the connection carrier (2),
- forming a radiation-transmissive body (3) around the optoelectronic semiconductor chip (1), and
- sawing the radiation-transmissive body (3) at an angle of < 90° with respect to the mounting surface (22) of the connection carrier (2) for generating a side surface (30) of the radiation-transmissive body at least in places, **characterized in that**
- a planarization layer (5) is sprayed onto the sawed side surface (30) of the radiation-transmissive body (3).

## Revendications

1. Composant semiconducteur optoélectronique avec
- un support de raccordement (2),
- une puce semiconductrice optoélectronique (1), qui est disposée sur une surface de montage (22) du support de raccordement (2), et
- un corps radiotransparent (3), qui entoure la puce semiconductrice (1), de sorte que le corps radiotransparent (3) enveloppe étroitement les surfaces externes de la puce semiconductrice optoélectronique (1) qui ne sont pas tournées vers le support de raccordement (2), sachant que
- le corps radiotransparent (3) contient une silicone,
- le corps radiotransparent (3) présente au moins une surface latérale (30), qui se produit dans un angle (β) inférieur à 90° par rapport à la surface de montage (22),
- la surface latérale (30) présente des traces d'un procédé de séparation,
**caractérisé en ce que**
- sur au moins l'une des surfaces latérales (30) du corps radiotransparent (3), qui est produite par un procédé de séparation, une couche de planarisation (5) est appliquée.

2. Composant semiconducteur optoélectronique selon la revendication précédente,
pour lequel
- les surfaces latérales (30) sont produites par un procédé de sciage.

3. Composant semiconducteur optoélectronique selon une quelconque des revendications précédentes,
pour lequel
- le corps radiotransparent (3) présente au moins une surface latérale (30), qui se produit au moins par zones dans un angle (β) entre 60° et 70° par rapport à la surface de montage (22) et est produite par un procédé de séparation.

4. Composant semiconducteur optoélectronique selon une quelconque des revendications précédentes,
pour lequel
- le corps radiotransparent (3) présente au moins deux surfaces latérales (30), qui se produisent respectivement au moins par zones dans un angle (β) inférieur à 90° par rapport à la surface de montage et sont produites respectivement par un procédé de séparation.

5. Composant semiconducteur optoélectronique selon la revendication précédente,
pour lequel
- le corps radiotransparent (3) présente au moins deux surfaces latérales (30), qui se produisent respectivement au moins par zones dans un angle (β) entre 60° et 70° par rapport à la surface de montage (22) et sont produites respectivement par un procédé de séparation.

6. Composant semiconducteur optoélectronique selon une quelconque des revendications précédentes,
pour lequel
- le corps radiotransparent (3) est directement adjacent à la surface de montage (22) du support de raccordement (2).

7. Composant semiconducteur optoélectronique selon une quelconque des revendications précédentes,
pour lequel
- le support de raccordement (2) présente un corps de base (20) qui est constitué avec une matière céramique, sachant que le corps de base (20) présente une épaisseur (D) qui est au maximum de 250 µm.

8. Procédé en vue de la fabrication d'un composant semiconducteur optoélectronique selon au moins une quelconque des revendications précédentes avec les étapes suivantes :
- mise à disposition d'un support de raccordement (2),
- fixation et mise en contact électrique d'une puce semiconductrice optoélectronique (1) sur une surface de montage (22) du support de raccordement (2),
- façonnement de la puce semiconductrice optoélectronique (1) avec un corps radiotransparent (3), et
- sciage du corps radiotransparent (3) dans un angle < 90° par rapport à la surface de montage (22) du support de raccordement (2) en vue de la production au moins par zones d'une surface latérale (30) du corps radiotransparent, **caractérisé en ce que**
- une couche de planarisation (5) est appliquée par pulvérisation sur la surface latérale sciée (30) du corps radiotransparent (3).
